# EUROPEAN PATENT APPLICATION

(11) **EP 1 225 722 A2**
(43) Date of publication of application: **24.07.2002**
(21) Application number: 01850228.6
(22) Date of filing: 27.12.2001
(51) Int. Cl.: H04L 12/28

(54) **Nonadjacent frequency scanning systems, methods and computer program products for cable modems**

(30) Priority: 22.01.2001 US 767177
(71) Applicant: TELEFONAKTIEBOLAGET LM ERICSSON, 126 25 Stockholm (SE)
(72) Inventor: Brown, Thomas A., Lynchburg, Virginia 24503 (US)
(74) Representative: Stenborg, Anders Vilhelm

(57) **Abstract**

Scanning of channels for a digital data signal that is received on one frequency of a group of frequencies in one of multiple channels is done by sequentially scanning frequencies in the group of frequencies such that each scan of a nonadjacent frequency is capable of detecting energy indicative of the digital data signal from the nonadjacent frequency and from frequencies that are adjacent thereto. In response to detecting energy indicative of the digital data signal in the nonadjacent frequency and frequencies that are adjacent thereto, the frequencies that are adjacent thereto may also be scanned to identify a frequency at which a carrier frequency is located. Sequential scanning may be accomplished by dividing a group of frequencies into a plurality of sets of frequencies at which the carrier frequency may be located. The frequencies of each set may then be interleaved with frequencies of other sets, and the frequencies of each set are sequentially scanned.

## Description

### BACKGROUND OF THE INVENTION

The present invention relates to communication systems and methods, in particular to cable modems and methods for scanning associated with cable modems.

Online usage has continued to grow despite slow speeds that may be available through existing dial-up telephone modem connections. The growing frustration of existing online users is driving demand for alternatives that offer higher-speed connections. One alternative to dial-up modem connections includes high-speed cable modems that may provide fast downstream data connections to provide high-speed access to packet based data over a cable TV network. Cable modems may allow access speeds that are much greater in comparison to dial-up alternatives. Unlike circuit-switched telephone networks where a caller is allocated a dedicated connection, cable modem users generally do not occupy a fixed amount of bandwidth during their online session. Instead, they may share the network with other active users and may use the network's resources only when they actually send or receive data in quick bursts. Thus, cable modem users can utilize all of the available bandwidth during the time they need to download their data packets. Another benefit cable modems can offer is constant connectivity, thereby allowing a user's PC to always be online with the network, without tying up the user's telephone line.

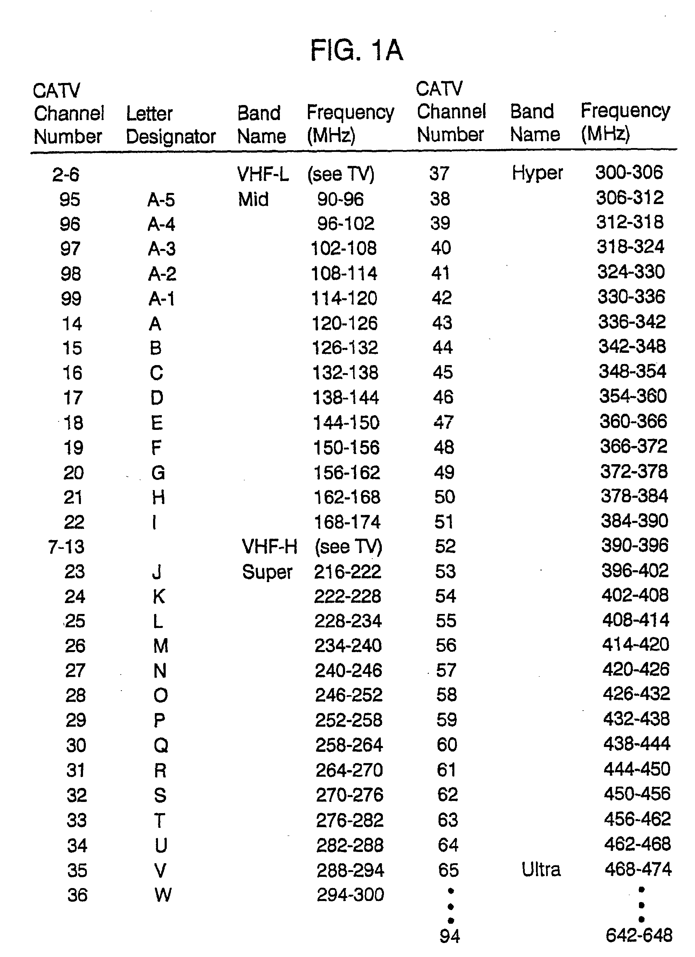

Cable TV systems recreate a portion of the over-the-air radio frequency (RF) spectrum within a coaxial cable line. In a cable network, data from the network to the user is referred to as downstream, whereas data from the user to the network is referred to as upstream. This recreated RF spectrum is divided into downstream data channels for transmitting data signals to users. In the U.S., the bandwidth of a downstream data channel is based on North American Digital video specifications (i.e., the International Telecommunications Union (ITU)-TR recommendations J.83 annex B). As shown in **FIG. 1A,** which is a reproduction from *Introduction to Communications Systems, 3*^{*rd*} *Edition* by Stremler, each standard downstream cable television channel occupies a six MHz bandwidth of RF spectrum. The number of channels a cable system may carry thus depends on the total downstream bandwidth.

Since cable data systems are comprised of many different technologies and standards, products from different vendors should be interoperable. To allow interoperability of systems, Multimedia Cable Network Systems (MCNS) has developed an initial set of cable modem requirements and interoperability tests known as Data Over Cable System Interface Specification (DOCSIS). For more information see http://www.cablelabs.com or http://cabledatacomnews.com/.

When a cable modem is installed in a cable network the modem generally determines which frequencies to listen to for downstream data. Conversely, for upstream data, the cable modem generally determines which frequency to transmit on. In the U.S., the Radio Frequency Interface Specification (SP-RFI-105-991105), which is sometimes referred to as the annex B implementation of the DOCSIS 1.0 Specification, specifies a sequence initialization procedures for a cable modem to follow.

According to these procedures, upon initialization or after signal loss, the cable modem acquires a downstream channel by scanning downstream channels for a DOCSIS signal, and then synchronizes with a cable modem terminal server (CMTS). The cable modem may have a non-volatile memory in which the last operational parameters are stored, and first attempts to reacquire the downstream channel stored therein. If this fails, the cable modem may then begin to sequentially scan carrier frequencies of each downstream channel until it finds a valid downstream DOCSIS signal. A valid DOCSIS signal may be identified by standard control data packets that are broadcast downstream from the CMTS.

In the U.S., cable system operators generally may not shift the carrier frequency of the DOCSIS signal. In other words, the carrier frequency of the DOCSIS signal is generally located at one specified location within the channel (e.g., the center frequency of the channel), and cable system operators may not change the location of that carrier frequency for a particular channel. Thus, in the worst case scenario, each channel would have to be examined at its center frequency to find a channel with a valid DOCSIS signal. For example, if there are 110 channels in a typical United States cable system, then in the worst case scenario it may be necessary to scan all 110 of the potential carrier frequencies to find a channel with a valid DOCSIS signal. A downstream DOCSIS signal is considered to be valid when the modem has achieved the following steps:
1) Synchronization of the Quadrature Amplitude Modulation (QAM) Symbol timing,
2) Synchronization of the Forward Error Correction (FEC) framing,
3) Synchronization of the Moving Picture Experts Group (MPEG) packatization, and
4) Recognition of a synch downstream Media Access Controller (MAC) messages.

The original DOCSIS 1.0/1.1 specification may vary throughout different locations in the world. For example, many nations follow a standard known as EURODOCSIS, which may also be known as the annex A implementation of DOCSIS.

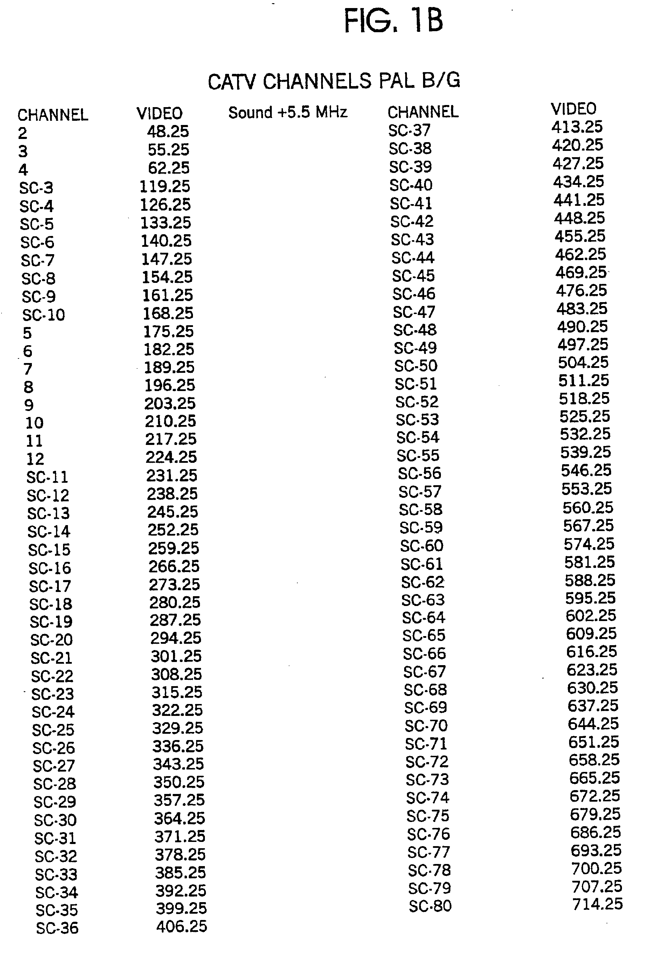

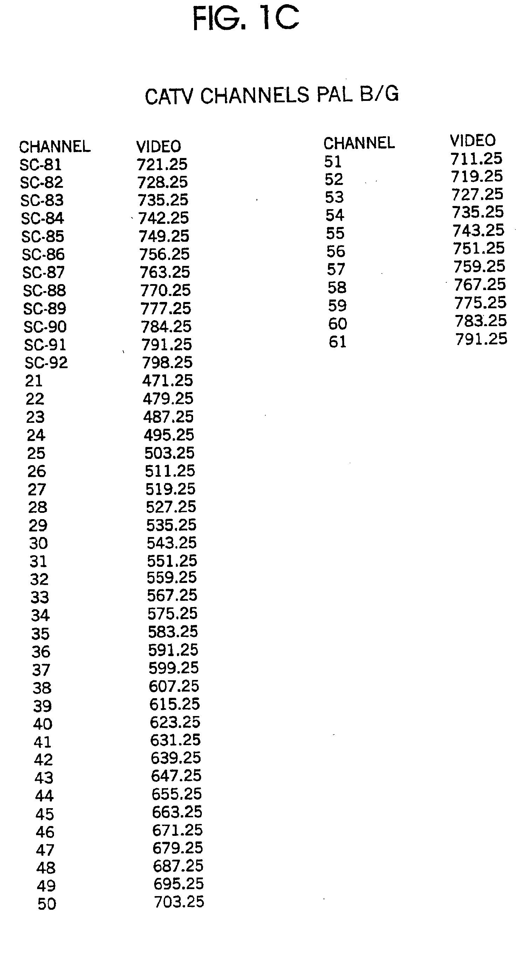

The organization of European cable systems is based on a European Digital Video Broadcast (DVB) frequency plan that is more complex than the frequency plan followed in the U.S. A list of exemplary channels in Europe is shown in **FIG. 1B,** which is a table showing carrier frequencies of cable television channels commonly used in Europe. As shown in **FIG. 1B,** the organization of the cable TV spectrum in Europe varies as some European operators utilize a seven MHz channel width, while others use an eight MHz channel width. For instance, as shown in **FIG. 1C,** the spacing between the SC50 channel and the SC49 channel is seven MHz, while the spacing between channel 50 and channel 49 is eight MHz. These varying channel bandwidths can greatly complicate scanning for downstream channels for a DOCSIS signal.

Another factor which may complicate the scanning process in Europe is that cable operators are free to move the carrier frequency of the DOCSIS signal within the channel. European cable operators may move the carrier frequency of video channels to avoid phase noise and/or intermodulation products due to multiple carriers on a single cable. By convention, cable operators may move the carrier frequency anywhere within the channel so long as they move the carrier frequency in 0.25 MHz increments. Because the modulating frequency is typically coupled onto the carrier frequency, moving the carrier frequency can correspondingly change the frequency band a particular channel occupies. Hypothetically, assume that a particular channel typically occupies a 7 MHz band located between 598.75 MHz and 605.75 MHz and has a carrier frequency at 602.25 MHz. If the carrier frequency was moved down 1 MHz to avoid phase noise, then that same channel would now occupy a band between 597.75 MHz and 604.75 MHz

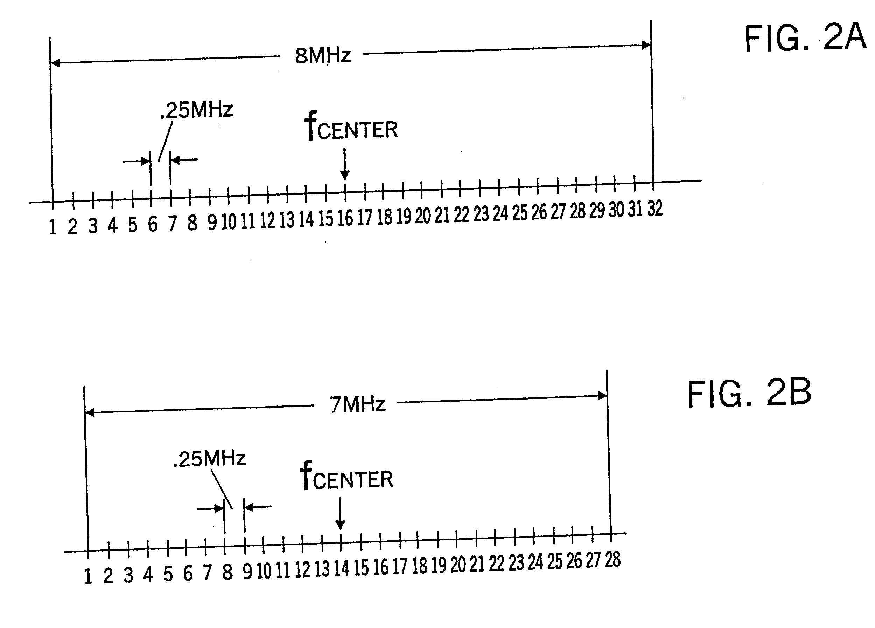

This organization of European cable TV spectrum can make sequential scanning for the carrier frequency of the DOCSIS signal an extremely time consuming process, since the number of potential locations per channel that need to be searched can be equal to the channel width divided by the 0.25 MHz quantization increment. As shown in **FIG. 2A**, because European cable operators may shift the carrier frequency anywhere within the channel (according to these increments of .25 MHz), an eight MHz channel, for example, may have 32 potential locations at which the carrier frequency of the DOCSIS signal could be located. Similarly, as shown in FIG.2B, a seven MHz channel may have 28 potential locations at which the carrier frequency of the DOCSIS signal could be located. Thus, in the worst case scenario, 32 locations would have to be searched per 8 MHz channel, while 28 locations would have to be searched per 7 MHz channel in order to find the carrier frequency of the DOCSIS signal.

Moreover, since the carrier frequency of the DOCSIS signal could be located within any available channel, each location within each of the channels may have to be searched before finding the carrier. For example, if the cable system has 100 eight MHz channels, then up to 3,200 individual locations may have to be checked to find the carrier frequency of the DOCSIS signal. As a result, in European cable systems, with 8 MHz channels, the scanning process may be up to 32 times more lengthy than it may be in comparison to the United States. Accordingly, there is a need for improved scanning for use during the initialization of cable modems.

### SUMMARY OF THE INVENTION

According to embodiments of the present invention, methods, cable modems, and computer program products are provided for scanning a plurality of channels for carrier frequency of a digital data signal. The digital data signal is received on one frequency of a group of frequencies in one of the plurality of channels. For example, the digital data signal may be a DOCSIS signal. Embodiments of the invention sequentially scan nonadjacent frequencies in a group of frequencies. Each scan of a nonadjacent frequency is capable of detecting energy indicative of the digital data signal from the nonadjacent frequency and from frequencies that are adjacent thereto. In response to detecting energy indicative of the digital data signal in the nonadjacent frequency and frequencies that are adjacent thereto, other embodiments may scan the frequencies that are adjacent thereto in order to identify a frequency at which the carrier frequency is located.

The sequential scan may be accomplished, for example, by dividing a group of frequencies into a plurality of sets of frequencies at which the carrier frequency may be located. The frequencies of each set are preferably chosen such that they are interleaved with frequencies of other sets. The frequencies of each set can then be sequentially scanned.

In other embodiments, the group of frequencies may be divided into any number of sets depending on the channel width, and other factors such as the allowable quantization of the carrier frequencies. For example, in some embodiments, the group of frequencies may be divided into a first set and a second set, and the frequencies of the second set may then be interleaved with frequencies of the first set. In other embodiments, the group of frequencies may be divided into a first set, a second set and a third set, and the frequencies of the second and third sets may be interleaved with the frequencies of the first set.

In addition, a frequency of the first set may be adjacent second and third frequencies of the second set. When this is the case, the sequential scanning may comprise scanning the first frequency to detect the digital signal. If scanning the first frequency results in detection of energy that may be indicative of the digital data signal at the second and third frequencies, then second and third frequencies in the vicinity of the first frequency may be scanned. Optionally, the second set of frequencies may be scanned to attempt to detect the digital data signal, when scanning of the first set of frequencies fails to center on the carrier frequency of the digital data signal.

In other embodiments of the present invention, scanning is provided in which a channel can be scanned to detect a carrier frequency of a digital data signal within the channel. The channel may include a set of potential carrier frequencies. A group of nonadjacent potential carrier frequencies, selected from the set of potential carrier frequencies, may be sequentially scanned. Each scan of a nonadjacent potential carrier frequency is capable of detecting or "locking" on energy indicative of the digital data signal from both the nonadjacent potential carrier frequency and from potential carrier frequencies that are adjacent thereto. If energy indicative of the digital data signal is detected in one of the nonadjacent frequencies and frequencies that are adjacent thereto, then the frequencies that are adjacent thereto may be individually scanned, if necessary, to attempt to identify where the carrier frequency is located. The groups of possible carrier frequencies may be divided into sets as described above.

In other embodiments, scanning a plurality of frequencies within a channel to detect a carrier frequency of a digital data signal in a modem is provided. A first set of frequencies is preferably scanned to detect or center on the digital data signal. If scanning of the first set of frequencies fails to detect the digital data signal, then a second set of frequencies, that are interleaved with the first set of frequencies, may then be scanned to detect the digital data signal. The first set of frequencies may include a first frequency and a second frequency. The second frequency is preferably spaced from the first frequency by a predetermined amount. Moreover the first set of frequencies may also include a third frequency. This third frequency is also preferably spaced apart from the second frequency by the predetermined amount.

It will be understood that the present invention may be provided as cable modems, scanning methods for cable modems, and /or computer program products for cable modems. Improved scanning of a plurality of channels for the carrier frequency of a digital data signal may thereby be provided.

### BRIEF DESCRIPTION OF THE DRAWINGS

**FIG. 1A** is a table showing a list of cable television channel frequencies in the United States with six MHz channels.

**FIG. 1B** is a table showing a list of cable television channel frequencies in Europe with both seven and eight MHz channels.

**FIG. 2A** is a graph illustrating an eight MHz channel used in the European cable television system having 32 possible locations where the DOCSIS carrier frequency could be located, each spaced apart at quantization increments of 0.25 MHz.

**FIG. 2B** is a graph illustrating a seven MHz channel used in the European cable television system having 28 possible locations where the DOCSIS carrier frequency could be located, each spaced apart at quantization increments of 0.25 MHz.

**FIG. 3A** is a flow chart showing scanning of a plurality of channels for a carrier frequency of a digital data signal, according to embodiments of the present invention.

**FIG. 3B** is a flow chart further illustrating techniques of sequentially scanning as shown in **FIG. 3A** above, according to embodiments of the present invention.

**FIG. 4** is a flow chart illustrating alternative techniques of sequentially scanning, according to embodiments of the present invention.

**FIG. 5** is a graph illustrating one possible order in which first and second frequency increments of an eight MHz channel shown in FIG 2A may be scanned in order to search for a DOCSIS signal, according to embodiments of the present invention.

**FIG. 6** is a graph illustrating one possible order in which first, second, and third frequency increments of an eight MHz channel shown in FIG 2A may be scanned in order to search for a DOCSIS signal, according to embodiments of the present invention.

**FIGs. 7A**, **7B** and **7C** are flow chart illustrations of scanning a plurality of channels for a DOCSIS signal, according to embodiments of the present invention.

**FIG. 8** is a block diagram of a cable modem that is configured to scan for a DOCSIS signal, according to embodiments of the present invention.

### DETAILED DESCRIPTION

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. Like numbers refer to like elements throughout.

Although the description of the embodiments herein refer to cable television systems, the present invention is also applicable to other cable communication systems. The scanning described herein may be useful in scanning a plurality of channels for a carrier frequency of a digital data signal present within a channel. As defined herein, a channel is a segment of spectrum that preferably includes a set of potential carrier frequencies. In addition, any references to a European cable system, etc. are exemplary only, and should not be construed as being limited to a European cable system. For example, the scanning techniques discussed herein could also be applied in the U.S. in an analogous manner by grouping the fixed carrier frequencies of each cable channel into a plurality of sets, and the scanning those sets according to the scanning techniques described herein.

As used herein, the phrase "detecting energy indicative of digital signal" shall be construed as. but is not necessarily limited to, an evaluation of whether a valid digital data signal (e.g., DOCSIS signal) has been found. This may be accomplished, for example, by energy measure, a 'digital lock' to a QAM signal, and/or actually decoding the MPEG frames and recognizing the DOCSIS frames.

When a cable modem is turned on, it generally first scans the downstream channels to find an active data signal. This active data channel is typically identified by a digital data signal, for example, a DOCSIS signal. Scanning described herein may be useful in, for example, a cable modem which is scanning for a DOCSIS type digital data signal. The digital data signal is received on one frequency of a group of frequencies typically in at least one of the plurality of channels.

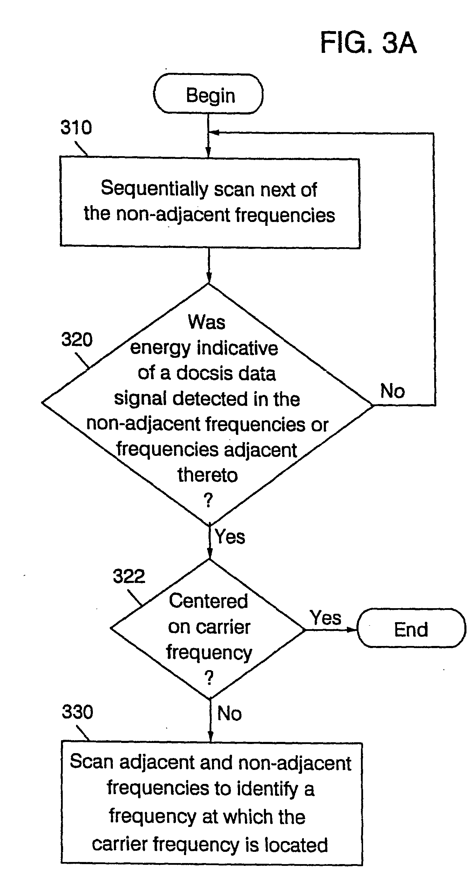

**FIG. 3A** is a flow chart showing scanning a plurality of channels for a carrier frequency of a digital data signal, according to embodiments of the present invention. At Block **310**, nonadjacent frequencies in a group of frequencies are sequentially scanned. This group of nonadjacent frequencies may be selected from a set of potential carrier frequencies. Since each nonadjacent frequency is a potential or possible carrier frequency, each scan of a particular nonadjacent frequency may detect energy indicative of the digital data signal from either the nonadjacent frequency itself and/or from frequencies that are adjacent to the particular nonadjacent frequency. When "energy" is detected, it is possible to lock on the frequency in which energy is detected.

Thus, at Block **320**, after each scan of the particular nonadjacent frequency, it is determined whether energy was detected that is indicative of the digital data signal. Again, energy indicative of the digital data signal may be detected from either the nonadjacent frequency itself and/or from frequencies that are adjacent to the particular nonadjacent frequency. If energy is not detected at Block **320,** then scanning progresses by sequentially scanning the next of the nonadjacent frequencies at Block **310**. On the other hand, once "energy" is detected in the nonadjacent frequency itself or from frequencies that are adjacent to the particular nonadjacent frequency, at Block **322** it is determined whether the modem has actually centered on to the carrier frequency. If it is determined, at Block **322**, that the modem has centered on to the carrier frequency, then scanning ends.

If it is determined at Block **322** that the modem has not centered on to the carrier frequency, at Block **330** frequencies that are adjacent thereto may be individually scanned in an attempt to center on to or identify the specific frequency at which the carrier frequency is located. At Block **330**, when energy indicative of the digital data signal is detected at a frequency, that frequency is locked on, and if that frequency does not include the DOCSIS signal, then corrections are attempted to center on to the carrier frequency.

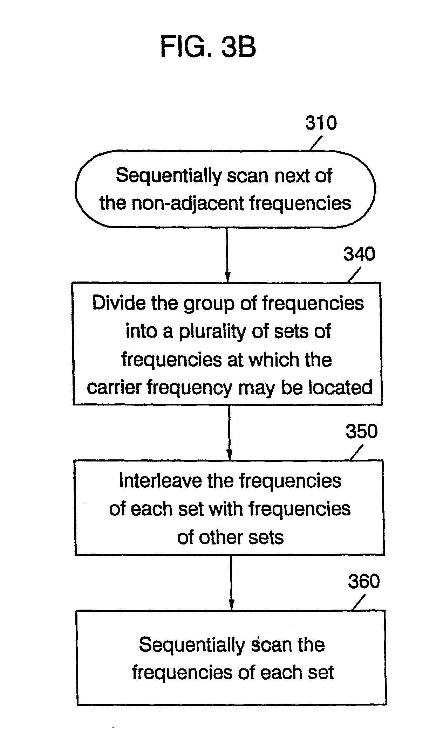

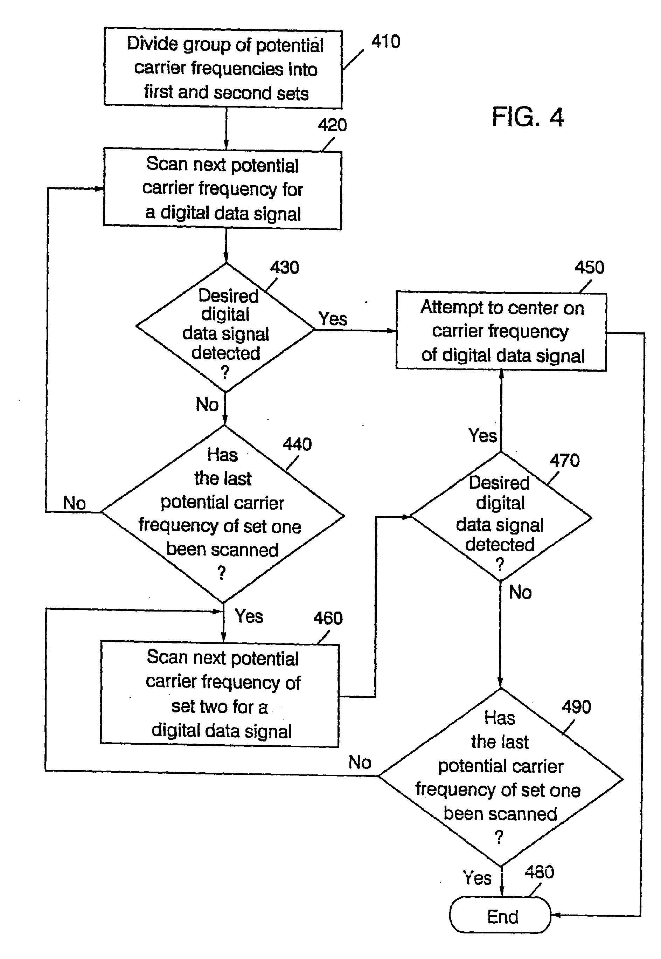

**FIG. 3B** is a flow chart further illustrating embodiments of sequentially scanning nonadjacent frequencies in a group of frequencies as discussed above with respect to Block **310** of FIG. **3A**. At Block **340**, for example, the group of potential carrier frequencies may be divided into a plurality of sets of frequencies at which the carrier frequency may be located. The group of frequencies may be divided into any number of sets. Specific examples of two sets will be discussed below with respect to **FIG. 4**. The number of sets may be chosen based on the organization of particular channels and will depend upon factors such as, but not limited to, the channel width and the permissible adjustment of the carrier frequency, sensitivity of the tuner circuitry, etc. Each of the sets may comprise, for instance, a set of discrete frequency values. Preferably, each member of the set is spaced apart in equal increments, although other relationships between increments could be utilized. At Block **350**, discrete frequency values of each set may be interleaved with discrete frequency values of other sets. At Block **360**, the potential carrier frequencies of each set can then be sequentially scanned.

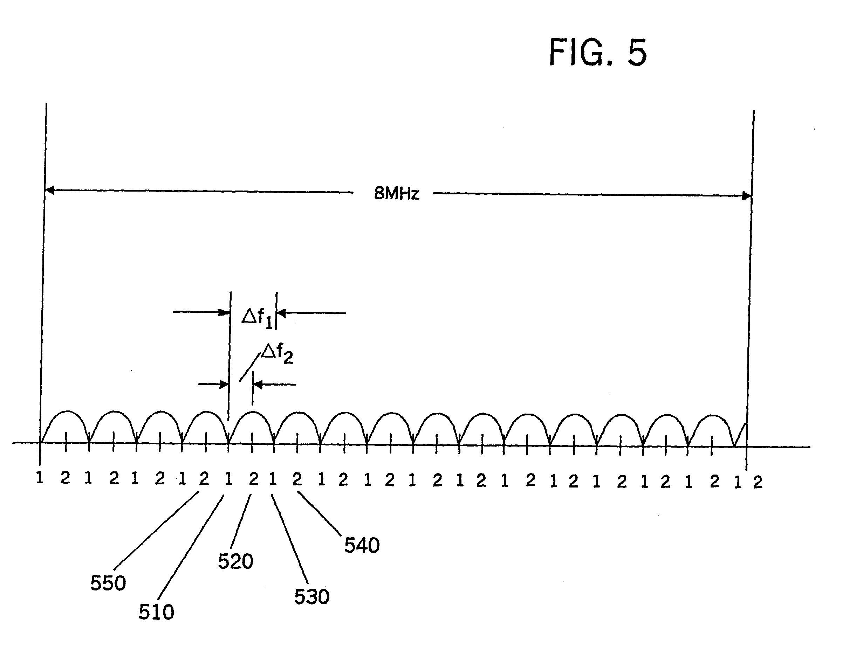

**FIG. 4** is a flow chart illustrating alternate embodiments of scanning according to embodiments of the present invention. In particular, **FIG. 4** shows specific embodiments useful in carrying out Blocks **340** through **360** in which potential carrier frequencies in an 8 MHz channel are divided into two sets to be scanned. This is also shown graphically in **FIG. 5**, which illustrates one possible order in which first and second frequency sets of an 8 MHz channel, as shown in **FIG 2A**, may be scanned in order to search for the digital data (e.g., DOCSIS signal). It should be appreciated that this division of the channel could apply to a channel of any width. Thus, at Block **410**, embodiments of present invention may divide the group of potential carrier frequencies into a first set, members of which are denoted by the numeral 1, and a second set, members of which are denoted by the numeral 2. As shown in **FIG. 5,** the frequencies of the second set are defined such that they are interleaved with frequencies of the first set.

As shown in **FIG. 5**, the first set of frequencies may include a first frequency **510** and a second frequency **530**. The second frequency **530** is preferably spaced from the first frequency **510** by a first predetermined amount *Δf*₁. The second set of frequencies can include a third frequency **520** and a fourth frequency **540**. The fourth frequency **540** is preferably spaced apart from the third frequency **520** by the first predetermined amount (Δ*f*₁), while the third frequency **520** is preferably spaced apart from the first frequency **510** by a second predetermined amount (Δ*f*₂). The fourth frequency **540** is also preferably spaced apart from the second frequency **530** by an amount equal to the second predetermined amount (Δ*f*₂). It should be appreciated that the first and second predetermined amounts preferably are different and more preferably are multiples of each other. Similarly, the fourth frequency **540** may also be spaced apart from the first frequency **510** by a amount different than and preferably greater than the first and second predetermined amounts.

Referring again to **FIG. 4**, at Block **420** the first potential carrier frequency of Set 1 is scanned for a digital data signal. After scanning each potential carrier frequency of Set 1, at Block **430** it is then determined whether a digital data signal (e.g., a DOCSIS signal) is detected. If the digital data signal is detected, at Block **450** an attempt is made to center on the carrier frequency of the digital data signal. On the other hand, if no digital data signal is detected at Block **430**, then at Block **440** it is determined whether or not the last potential carrier frequency of Set 1 has been scanned. If it is determined at Block **440** that the last potential carrier frequency of Set 1 has not been scanned, then at Block **420**, the next potential carrier frequency of Set 1 is scanned for a digital data signal. Blocks **430**, **440** and **450** are again repeated. However, if at Block **440** it is determined that the last potential carrier frequency of Set 1 has been scanned, then at Block **460** the first potential carrier frequency of Set 2 is scanned for digital data signal. Then, at Block **470** it is again determined whether or not a digital data signal is detected. If a digital data signal is detected at Block **470**, then at Block **450** an attempt is made to center on the carrier frequency of the digital data signal.

On the other hand, if no digital data signal is detected at Block **470**, then at Block **490** it is determined whether or not the last potential carrier frequency of Set 2 has been scanned. If it is determined at Block **490** that the last potential carrier frequency of Set 2 has not been scanned, then at Block **460**, the next potential carrier frequency of Set 2 is scanned for a digital data signal. Blocks **470**, **490** and **450** may then again repeated. However, if at Block **490** it is determined that the last potential carrier frequency of Set 2 has been scanned, then the scanning may end at Block **480**.

Preferably, as shown in **FIG. 5**, the potential carrier frequencies of Sets 1 and 2 are sequentially scanned. However, it should be appreciated that the frequencies do not necessarily need to be scanned sequentially, and other orders of scanning could be utilized.

Referring again to **FIG. 5**, a first frequency **510** in the Set 1 is adjacent frequencies **520**, **550** of the Set 2. In other embodiments of the present invention, the first frequency **510** may be scanned to detect the digital data signal. If no energy is detected in the scan of the first frequency **510**, then the next frequency **530** of the Set 1 can be sequentially scanned. On the other hand, scanning the first frequency **510** may result in detection of energy indicative of the digital data signal at the first frequency **510**. Because the energy detected due to a digital data signal at the frequencies **520**, **550** of the Set 2 may result in a lock on those frequencies **520**, **550**, the frequencies **520**, **550** of the Set 2 that are in the vicinity of the first frequency **510** can be scanned to center on the carrier frequency of the digital data signal. If scanning of the Set 1 of frequencies (denoted by the numeral 1) fails to identify the carrier frequency of the digital data signal, then the Set 2 of frequencies (denoted by the numeral 2) may be scanned to attempt to detect the digital data signal.

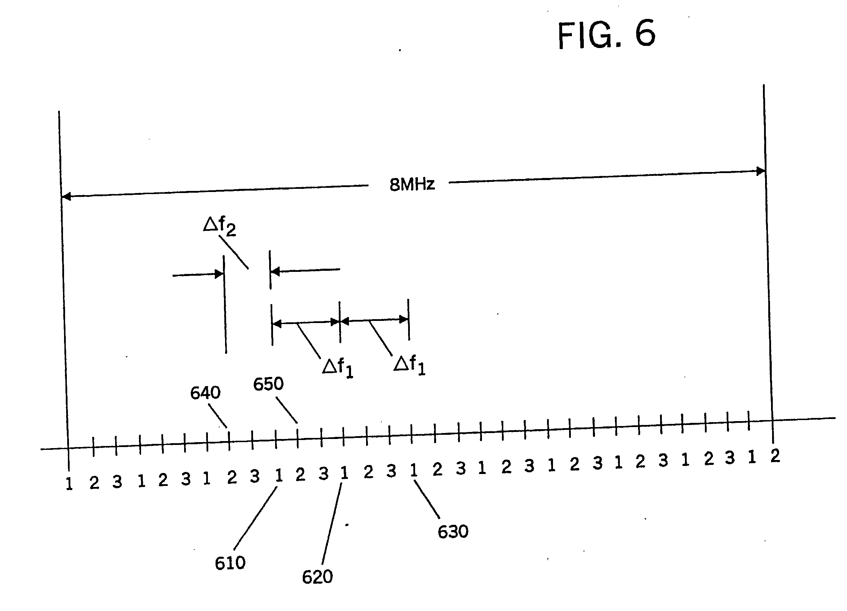

Referring now to **FIG. 6**, shown is a graph illustrating an exemplary order for scanning first, second, and third frequency sets of an eight MHz channel (similar to that shown in **FIG 2A)** in order to search for the DOCSIS signal according to embodiments of the invention. While an 8 MHz channel is used in this example, it should be appreciated that this scheme is applicable to channels of any width. In **FIG. 6**, the group of frequencies may be divided into a Set 1 of potential carrier frequencies denoted by the numeral 1, a Set 2 of potential carrier frequencies denoted by the numeral 2, and a third set of potential carrier frequencies denoted by the numeral 3. The discrete frequency values of the second and third sets may be interspersed among or interleaved with the discrete frequency values of the Set 1. As shown in **FIG. 6,** the Set 1 of frequencies (denoted by the numeral 1) may include a first frequency **610,** a second frequency **620,** and third frequency **630.** The first and second, and the second and third frequencies are preferably spaced apart by a first predetermined amount (Δ*f*₁), repeatedly. The Set 2 of frequencies (denoted by the numeral 2) can include a fourth frequency **640** and a fifth frequency **650.** The fifth frequency **650** is preferably spaced apart from the fourth frequency **640** by the first predetermined amount, while the fourth frequency **640** is preferably spaced apart from the first frequency 610 by a second predetermined amount (Δ*f*₂) that is less than the first. The fifth frequency **650** is also preferably spaced apart from the second frequency **620** by the second predetermined amount.

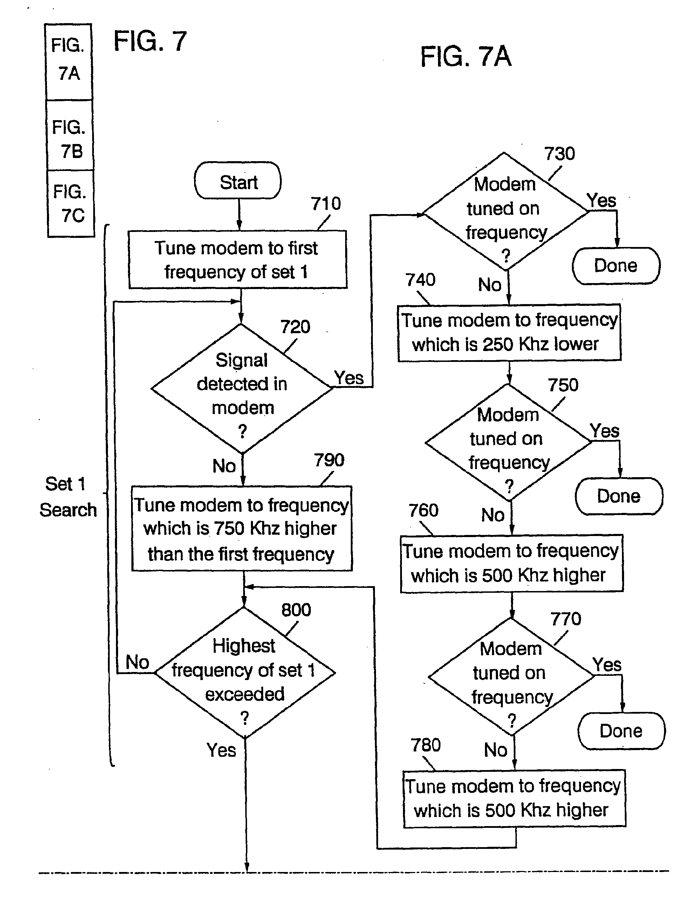

**FIGs. 7A - 7C** are flow chart illustrations of scanning a plurality of channels for a DOCSIS signal, according to embodiments of the present invention. In this particular example, it is assumed that the modem can lock on the carrier frequency at one channel spacing off the carrier frequency, and that the modem can sense that it is off the carrier frequency by at least 250 kHz (which is equal to the allowable quantization increment in Europe). However, the quantization increment of 250 kHz is exemplary only, and should not be construed as limiting. Quantization increments other than 250 kHz could also be used.

Preliminarily, it should be recognized that a set of spaced-apart frequencies are divided into a plurality of interleaved sets. Members of each set are preferably spaced apart from other members of that same set by a first predetermined amount, while members of each set are preferably spaced apart from corresponding members of next set by a second predetermined amount. In the following discussion, for example, members of each set are preferably spaced apart from other members of that same set by 750 KHz, while members of each set are preferably spaced apart from corresponding members of the next set by 250 kHz. However, any reference to amounts of 250 kHz, 500 kHz, and 750 kHz is for example only, and each amount could be any other amount that satisfies the relationships set forth herein. In addition, the example below details scanning using three interleaved sets, however, depending upon factors such as the width of the channel and allowable quantization increment, any number of sets could be used. Moreover, interleaving of the sets is not necessarily required. According to the order specified below, Set 1 is searched first, Set 2 is searched second, and set 3 is searched last. However, the sets do not need to be searched in any particular order. Rather the sets may be searched in whatever order will provide the most efficient acquisition of a digital data signal (e.g., a DOCSIS signal).

Referring now to **FIG. 7A**, shown is a flowchart illustrating techniques for scanning Set 1 of the frequencies. After starting the scan, at Block **710**, the modem is tuned to the lowest or first frequency of Set 1. At Block **720**, it is then determined whether a digital data signal is detected in the modem. This may he accomplished, for example, by determining whether or not energy is detected that is indicative of the digital data signal (e.g., DOCSIS signal).

If a digital data signal is not detected in the modem at Block **720**, then at Block **790** the modem is tuned to a frequency that is 750 kHz higher than the first frequency of Set 1. At Block **800** it is then determined whether this new frequency exceeds the highest frequency of Set 1. For sake of brevity, the operations at Block **800** will be discussed below in further detail.

If a digital data signal is detected in the modem at Block **720**, the modem locks on this frequency and then at Block **730** it is determined whether the modem is tuned on the carrier frequency of the digital data (e.g., DOCSIS) signal. If modem is tuned on the carrier frequency of the digital data (e.g., DOCSIS) signal, the scan is complete and ends. If the modem is not tuned onto the carrier frequency of the digital data (e.g., DOCSIS) signal, then the modem is tuned in an attempt to center on the carrier frequency. While this attempt to center on the carrier frequency could be accomplished in many different ways, one example will now be discussed with respect to Block **740** through **780**.

When a DOCSIS channel is found in Set 1, it is either "on the carrier frequency" or "off the carrier frequency" by 250 kHz. If the frequency found is "on the carrier frequency", then the search is complete and ends. If the frequency found is "off the carrier frequency", and the direction is known, then corrections are made to center on the carrier frequency and the search is complete. However, if the frequency is "off the carrier frequency", and the direction is unknown, then "low" and "high" correction of frequency are attempted sequentially until a frequency lock is accomplished. For example, at Block **740**, the modem is centered on a frequency that is 250 kHz lower than the first frequency of Set 1 (Block **710**). At Block **750**, it is determined whether the modem is centered on the carrier frequency of the digital data (e.g., DOCSIS) signal. If modem is centered on the carrier frequency of the digital data (e.g., DOCSIS) signal, the scan is complete and ends. If the modem is not centered onto the carrier frequency of the digital data (e.g., DOCSIS) signal, then at Block **760**, the modem is tuned to a frequency that is 500 kHz higher than the frequency tuned to at Block **740** in an attempt to lock onto the carrier frequency. At Block **770**, it is again determined whether the modem is tuned on the carrier frequency of the digital data (e.g., DOCSIS) signal. As discussed above, if the modem is tuned on the carrier frequency of the digital data (e.g., DOCSIS) signal, the scan is complete and ends. If the modem is not tuned onto the carrier frequency of the digital data (e.g., DOCSIS) signal, then at Block **780**, the modem is tuned to a frequency that is 500 kHz higher than the frequency tuned to at Block **760** in yet another attempt to center onto the carrier frequency.

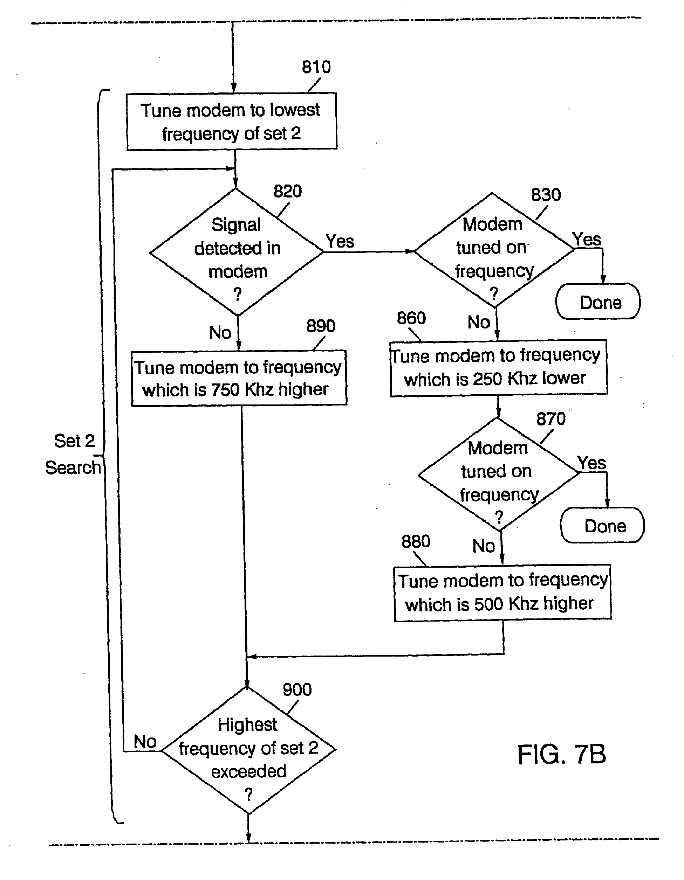

A determination is then made at Block **800** whether the frequency tuned to at Block **780** exceeds the highest frequency of Set 1. If at Block **800** it is determined that the frequency tuned to at Block **780** does not exceed the highest frequency of Set 1 at Block **800**, then it is again determined at Block **720** whether the digital data signal is detected in the modem, and the process described above repeats itself. However, if at Block **800** it is determined that the frequency tuned to at Block **780** does exceed the highest frequency of Set 1, then the search of Set 2 begins, as will now be discussed with regard to Block **810** of **FIG. 7B**.

Referring now to **FIG. 7B**, shown is a flowchart illustrating techniques for scanning the Set 2 of frequencies. After scanning the Set 1 of frequencies, according to **FIG. 7A**, at Block **810** the modem is tuned to the lowest frequency of Set 2 (denoted by the numeral 2 in **FIG. 6**). At Block **820,** it is then determined whether a digital data signal is detected in the modem, as discussed above. If a digital data signal is not detected in the modem at Block **820**, then at Block **890** the modem is tuned to a frequency that is 750 kHz higher than the first (or lowest) frequency of Set 2. At Block **900**, it is then determined whether the frequency tuned to at Block **890** exceeds the highest frequency of Set 2. For sake of brevity, the operations at Block **900** will be discussed below.

If a digital data signal is detected in the modem at Block **820**, the modem locks on the frequency at which the digital signal is detected, then at Block **830** it is determined whether the modem is centered on the carrier frequency of the digital data (e.g., DOCSIS) signal. If modem is centered on the carrier frequency of the digital data (e.g., DOCSIS) signal, the scan is complete and ends. If the modem is not centered onto the carrier frequency of the digital data (e.g., DOCSIS) signal, then the modem is tuned in an attempt to center onto the carrier frequency. While this attempt to center on to the carrier frequency could be accomplished in many different ways, one example will now be discussed with respect to Blocks **860** through **880.**

Techniques for scanning Set 2, in an attempt to center on to the carrier frequency, may be similar to the techniques used with respect to Set 1, however, when searching Set 2 it is known that the frequencies for Set 1 have already been checked. Thus, only frequencies that are above the lowest frequency of Set 2 need to be searched to center on to the carrier frequency. Thus, if at Block **830,** the modem is not centered onto the carrier frequency of the digital data (e.g., DOCSIS) signal, then at Block **860** the modem is tuned to a frequency that is 250 kHz higher than the frequency tuned to at Block **810** in another attempt to center on the carrier frequency. At Block **870,** it is again determined whether the modem is centered on the carrier frequency of the digital data (e.g., DOCSIS) signal. As discussed above, if modem is centered on the carrier frequency of the digital data (e.g., DOCSIS) signal, the scan is complete and ends. If the modem is not centered on the carrier frequency of the digital data (e.g., DOCSIS) signal, then at Block **880,** the modem is tuned to a frequency that is 500 kHz higher than the frequency tuned to at Block **860** in another attempt to center on the carrier frequency.

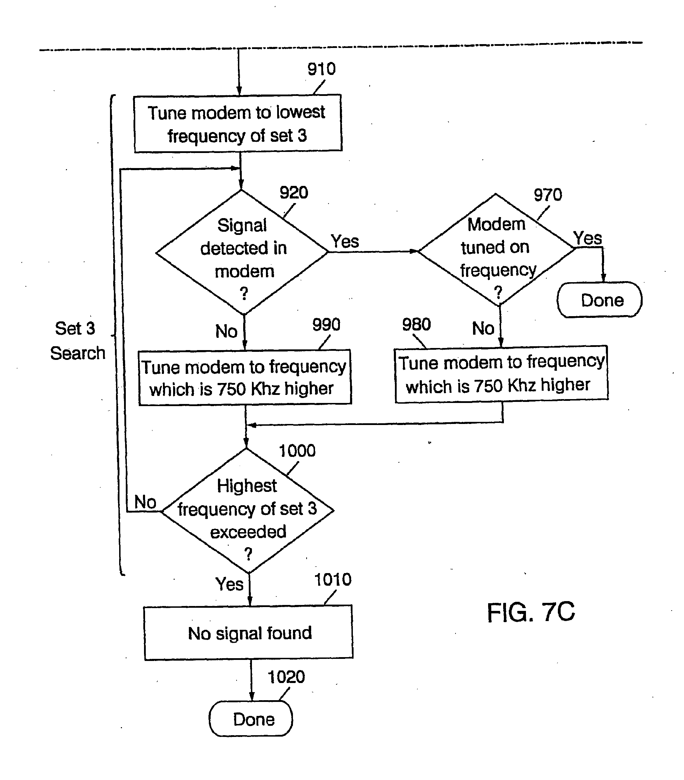

A determination is then made at Block **900** whether the frequency tuned to at Block **880** exceeds the highest frequency of Set 2. If at Block **900** it is determined that the frequency tuned to at Block **880** does not exceed the highest frequency of Set 2, then it is again determined at Block **820** whether the digital data signal is detected in the modem, and the process described above repeats itself. However, if at Block **900** it is determined that the frequency tuned to at Block **880** does exceed the highest frequency of Set 2, then the search of set 3 begins, as will now be discussed with regard to Block **910** of **FIG. 7C.**

Still referring to **FIG. 7C,** techniques for scanning the third set of frequencies will now be discussed. After scanning the Set 2 of frequencies, at Block **910** at Blocks **810** through **900,** the modem is tuned to the lowest frequency of the third set (denoted by the numeral 3 in **FIG. 6**). At Block **920,** it is then determined whether a digital data signal is detected in the modem, as discussed above. If a digital data signal is not detected in the modem at Block **920,** then at Block **990** the modem is tuned to a frequency that is 750 kHz higher than the first (or lowest) frequency of Set 3. At Block **1000** it is then determined whether the frequency tuned to at Block **990** exceeds the highest frequency of Set 2. As above, for sake of brevity, the operations at Block **900** will be discussed below.

The techniques for scanning Set 3, in an attempt to center on to the carrier frequency, may be similar to the techniques used with respect to Set 2, however, when searching Set 3 it is known that the frequencies at 250 kHz on each side of the frequency locked onto have already been checked. Thus, only the freouencies that are centered on the carrier frequency need to be searched to center on to the carrier frequency.

If a digital data signal is detected in the modem at Block **920,** the frequency at which the digital data signal is detected is locked onto and then at Block **970** it is determined whether the modem is tuned on the carrier frequency of the digital data (e.g., DOCSIS) signal. If it is determined at Block **970** that the modem is centered on the carrier frequency of the digital data (e.g., DOCSIS) signal, the scan is complete and ends. However, if the modem is not centered onto the carrier frequency of the digital data (e.g., DOCSIS) signal, then at Block **980** the modem is tuned to a frequency that is 750 kHz higher than the frequency tuned to at Block **910,** in another attempt to center onto the carrier frequency.

A determination is then made at Block **1000** whether the frequency tuned to at Block **970** exceeds the highest frequency of Set 3. If at Block **1000** it is determined that the frequency tuned to at Block **970** does not exceed the highest frequency of Set 3, then it is again determined at Block **920** whether the digital data signal is detected in the modem, and the process described above repeats itself. However, if at Block **1000** it is determined that the frequency tuned to at Block **970** does exceed the highest frequency of Set 3, then it is determined that no signal is found at Block **1010,** and the search of that particular channel end at Block **1020.** If the search of Sets 1, 2 and 3 does not result in acquisition of a DOCSIS signal, then other channels in the cable system can then be searched in the same manner discussed above with respect to **FIGs. 7A** and **7B** until a DOCSIS signal is acquired.

In the above example, it should be appreciated that these scanning techniques may result, on average, in a three-to-one improvement in scan time. In a worst case scenario, these scanning techniques may take the same maximum time as a direct, sequential search of each possible frequency at which the carrier frequency of the DOCSIS signal or digital data signal may be located.

It should also be appreciated that any improvement in scan time may be dependent on the number of sets that the potential carrier frequencies are divided into. For example, when two sets are used (as shown in **FIG. 5**), a 2 to 1 average improvement in scan time may be possible, whereas when five interleaved sets are used, a 5 to 1 average improvement in scan time may be possible. However, in a worst case scenario, these scanning techniques will take the same maximum time as a straight, sequential search.

It should also be appreciated that if the "off carrier frequency" lock characteristic is not symmetric, then the correction direction should be made to favor the asymmetry of the "off carrier frequency" lock characteristic. For example, if the digital data signal is centered on 120 MHz and a scan is performed at 119.5 MHz or 120.5 MHz, it is possible, due to characteristics of the scanning mechanism, that the modem may detect and "lock on" the carrier frequency at 119.5 or 119,75 MHz, but not at 120.25 or 120.5 MHz. Thus, the bandpass of the scanning mechanism may have a skewed locking characteristic that does not lock on the carrier frequency with the same probability on each side. The correction direction should be made in favor of the asymmetry of the locking characteristic. In the example described above, if the carrier is locked when searched at 119.5 MHz the possible center frequencies less than 119.5 MHz do not need to be checked as the modem cannot lock if the search frequency is above the actual center frequency.

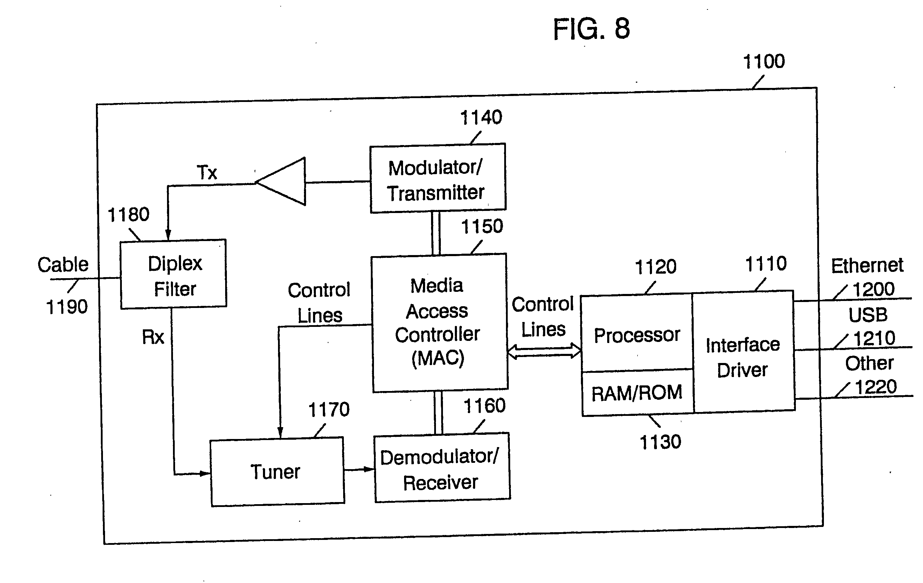

It will be understood that the present invention may be provided as scanning methods for cable modems, computer program products for use in cable modems, and cable modems. **FIG. 8** is a block diagram of a cable modem **1100** including a system for scanning for a digital data signal according to embodiments of the present invention. As shown in **FIG. 8**, the cable modem **1100** is coupled to a cable network **1190**. Data is transferred between a CMTS (not shown) and a cable network device by a media access controller **1150.** The media access controller accepts data transfers from the CMTS if the identifier (i.e., address) included in the data transfer matches the associated identifier of the cable modem **1100**. The data transfer can include information intended for one or more devices at a subscriber location, such as a user device. The transfers may include an address specifying which end user device coupled to the cable modem **1100** is the ultimate destination of the data transfer.

The media access controller **1150** is coupled to a radio frequency tuner **1170** as well as other circuitry such as a modulator **1140** that modulates the data and a demodulator **1160** that demodulates the data included in the data transfers, to put the data in an appropriate form for transmission and reception from the cable network (not shown). For example, data transfers from the CMTS (not shown) may be received over a channel on the downstream side of the cable network (not shown) and demodulated by a demodulator **1160** and provided to the media access controller **1150**. In turn, data transfers to the CMTS may be modulated by the modulator **1140** and transferred over a second channel on the upstream side of the cable network. Again, as used herein, the terms "upstream side" or "upstream channel" refer to communications to the CMTS from a cable modem **1100**, and the terms "downstream side" or "downstream channel" refer to communications from the CMTS to the cable modem **1100**. It is further understood that the upstream channel and downstream channel of the cable network will typically not be provided by separate physical cabling, but will instead typically be allocated a different frequency or frequencies (and/or timeslots where Time Division Multiple Access (TDMA) is provided). In other words, the downstream channel may be allocated a different frequency range at which signals are modulated (carrier frequency) than the upstream channel.

It will be appreciated that the modulator **1140** and demodulator **1160** and other components of the cable modem **1100** may be implemented using a variety of hardware and software, such as an Application Specific Integrated Circuit (ASIC) and programmable logic devices such as gate arrays, and/or software or firmware running on a computing device such as a microprocessor, microcontroller or Digital Signal Processor (DSP). It will also be appreciated that, although functions of the modulator **1140** and demodulator **1160** may be integrated in a single device, such as a single ASIC microprocessor **1120**, they may also be distributed among several devices. Aspects of the modulator **1140** and demodulator **1160** may also be combined in one or more devices, such as an ASIC, DSP, microprocessor or microcontroller.

The tuner **1170** may lock on frequencies that are off frequency by a certain amount since the tuner **1170** typically has a bandwidth that is wider than, for example, 0.25 MHz. In **FIG. 6**, during a scan of Set 1 frequencies, for example, the tuner **1170** may detect a carrier of the digital data signal located in a Set 2 or 3 frequency period. The bandwidth or sensitivity of the tuner **1170** determines how well the tuner **1170** will detect energy when off center from a carrier frequency. This sensitivity varies from tuner to tuner, and conventionally, a tuner may lock on downstream signals within range of -17 dBM to +10 dBM.

The processor **1120**, media access controller **1150**, demodulator **1160** and tuner **1170** may operate together to carry out scanning as described above. Thus, the tuner **1170** can be configured to scan a plurality of channels for a carrier frequency of a digital data signal that is received on one of a group of frequencies in one of the plurality of channels. In other embodiments of the present invention, the tuner **1170** may be configured to scan a plurality of frequencies within a channel to detect a carrier frequency of a digital data signal within the channel. The channel may include a set of potential carrier frequencies. The tuner may be controlled by a controller that may include, for example, the media access controller **1150**, the processor **1120**, and/or other elements. The controller can be configured to control the tuner **1170** to sequentially scan (a group of) nonadjacent (potential carrier) frequencies selected from a set of potential carrier frequencies, in accordance with the techniques discussed herein. The controller may also be responsible for detecting energy indicative of the digital data signal.

The processor **1120** also can coordinate operations of the cable modem **1100** to provide the selected services to the subscriber. The processor **1120**, such as a microprocessor, microcontroller or similar data processing device, may execute program instructions stored in the memory **1130** of the cable modem **1100**, such as a Dynamic Random Access Memory (DRAM), Electrically Erasable, Programmable Read-Only Memory (EEPROM), or other storage device. The processor **1120** is further operatively associated with the interface driver components of the cable modem **1100** as well as the modulator **1140**, media access controller **1150**, demodulator **1160,** tuner **1170**, and diplex filter **1180**, operations of which are known to those skilled in the art and will not be discussed further herein.

The interface driver **1110** provides the data received from the processor **1120** to the addressed user device and provides data from user devices to the processor **1120** for transfer to the CMTS. The interface driver **1110** may be a controller suitable for interfacing to at least one user device, using, for example, an ethernet **1200**, a universal serial bus (USB) **1210** or other type of interface **1220** known to those skilled in the art. The media access controller **1150**, the processor **1120** and the interface driver **1110** together comprise a cable modem.

The cable modem **1100** may also include a signal detection circuit coupled to the upstream side of the cable network and an interface so as to provide access to the upstream side of the cable network for signal measurement. Preferably, the signal detection circuit **1180** is a signal power measurement circuit.

The cable modem **1100** may further include a timing circuit and a signal identification circuit. The timing circuit and signal identification circuit may be implemented within the processor **1120.** However, they may alternatively be provided as discrete circuitry separate from the processor **1120** which controls the media access controller **1150** and the interface driver **1110** or as code executing on a separate processor or as a combination of hardware and software.

As will be appreciated by those of skill in the art, the above-described aspects of the present invention in **FIGs. 1** through **7C** may be provided by hardware, software, or a combination of the above. While various components of the cable modem device **1100** have been illustrated in **FIG. 8**, in part, as discrete elements, they may, in practice, be implemented by a microcontroller including input and output ports and running software code, by custom or hybrid chips, by discrete components or by a combination of the above. For example, media access controller **1150** may be implemented in part as code executing on the processor **1120**. Similarly, the scanning device may, in practice, be implemented by a microcontroller including input and output ports and running software code, by custom or hybrid chips, by discrete components or by a combination of the above.

As mentioned above, the present invention may also take the form of a computer program product on a computer-readable storage medium having computer-readable program code means embodied in the medium. Any suitable computer readable medium may be utilized including hard disks, CD-ROMs, optical storage devices, or magnetic storage devices.

Various aspects of the present invention are illustrated in detail in the preceding Figures, including flowchart illustrations of **FIGs. 3A, 3B, 4**, **7A** - **7C**. It will be understood that each block of the flowchart illustrations of **FIGs. 3A**, **3B, 4**, **7A - 7C**, and combinations of blocks in the flowchart illustrations, can be implemented by computer program instructions. These computer program instructions may be provided to a processor or other programmable data processing apparatus to produce a machine, such that the instructions which execute on the processor or other programmable data processing apparatus create means for implementing the functions specified in the flowchart block or blocks. These computer program instructions may also be stored in a computer-readable memory that can direct a processor or other programmable data processing apparatus to function in a particular manner, such that the instructions stored in the computer-readable memory produce an article of manufacture including instruction means which implement the functions specified in the flowchart block or blocks.

Accordingly, blocks of the flowchart illustrations of **FIGs. 3A**, **3B**, **4**, **7A**- **7C** support combinations of means for performing the specified functions, combinations of steps for performing the specified functions and program instruction means for performing the specified functions. It will also be understood that each block of the flowchart illustrations of **FIGs. 3A**, **3B**, **4**, **7A**- **7C**, and combinations of blocks in the flowchart illustrations, can be implemented by special purpose hardware-based computer systems which perform the specified functions or steps, or by combinations of special purpose hardware and computer instructions.

As discussed above, in a European cable system, the scanning process can be rather lengthy since the digital data signal or DOCSIS signal, may be located in many different locations within a particular channel. Based on an allowable quantization of 0.25 MHz, the carrier frequency of a DOCSIS signal can be located at 32 possible locations in an eight MHz channel or alternatively at 28 possible locations in a seven MHz channel. Moreover, the particular DOCSIS signal could also be located on any one of a number of channels thereby complicating this overall scanning process by a factor equal to the number of channels. The present invention can solve these and other problems by providing improved methods of scanning a plurality of channels for the carrier frequency of a DOCSIS signal.

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. In a cable modem, a method of scanning a plurality of channels for a carrier frequency of a digital data signal, the digital data signal being received on one of a group of frequencies in one of the plurality of channels, the method comprising:
sequentially scanning nonadjacent frequencies in the group of frequencies, wherein each scan of a nonadjacent frequency is capable of detecting energy indicative of the digital data signal from the nonadjacent frequency and from frequencies that are adjacent thereto.

2. The method according to Claim 1, further comprising:
scanning the frequencies that are adjacent thereto to thereby identify a frequency at which the carrier frequency is located, in response to detecting energy indicative of the digital data signal from the nonadjacent frequency and from frequencies that are adjacent thereto.

3. The method according to Claim 1, wherein the sequentially scanning comprises:
dividing the group of frequencies into a plurality of sets of frequencies at which the carrier frequency may be located, wherein frequencies of each set are interleaved with frequencies of other sets; and
sequentially scanning the frequencies of each set.

4. The method according to Claim 3, wherein the group of frequencies are divided into a first set and a second set, and wherein the frequencies of the second set are interleaved with frequencies of the first set.

5. The method according to Claim 3, wherein the group of frequencies are divided into a first set, a second set, and a third set, and wherein the frequencies of the second and third sets are interleaved with frequencies of the first set.

6. The method according to Claim 4, wherein a first frequency in the first set is adjacent second and third frequencies of the second set and wherein the sequentially scanning comprises:
scanning the first frequency to detect a digital data signal; and
scanning the second and third frequencies in the vicinity of the first frequency, if scanning the first frequency results in detection of energy indicative of the digital data signal at the second or third frequencies.

7. The method according to Claim 1, wherein the digital data signal is a DOCSIS signal.

8. The method of scanning according to Claim 4, further comprising scanning the second set of frequencies to attempt to detect the digital data signal, if scanning the first set of frequencies fails to identify the carrier frequency of the digital data signal

9. In a cable modem, a method of scanning a channel for a carrier frequency of a digital data signal within the channel, the channel including a set of potential carrier frequencies, the method comprising:
sequentially scanning a group of nonadjacent potential carrier frequencies selected from the set of potential carrier frequencies, wherein each scan of a nonadjacent potential carrier frequency is capable of detecting energy indicative of the digital data signal from both the nonadjacent potential carrier frequency and from potential carrier frequencies that are adjacent thereto.

10. The method according to Claim 9, further comprising the step of:
individually scanning the frequencies that are adjacent thereto to thereby identify a frequency at which the carrier frequency is located, in response to detecting energy indicative of the digital data signal from the nonadjacent potential carrier frequency and from potential carrier frequencies that are adjacent thereto.

11. The method according to Claim 9, wherein the sequentially scanning comprises:
dividing the group of potential carrier frequencies into a plurality of sets, each of the sets comprising a set of discrete frequency values at which the carrier frequency may be located, wherein discrete frequency values of each set are interleaved with discrete frequency values of other sets; and
sequentially scanning the potential carrier frequencies of each set.

12. The method according to Claim 11, wherein the group of potential carrier frequencies are divided into a first set and a second set, and wherein the discrete frequency values of the second set are interleaved with discrete frequency values of the first set.

13. The method according to Claim 11, wherein the group of potential carrier frequencies are divided into a first set, a second set, and a third set, and wherein the discrete frequency values of the second and third sets are interleaved with discrete frequency values of the first set.

14. The method according to Claim 12, wherein the discrete frequency values of the first set include a frequency value and wherein other frequency values are in the vicinity of the frequency value, the method further comprising the steps of:
scanning the frequency value to detect a digital data signal; and
incrementally scanning the other frequency values in the vicinity of the first frequency value until the carrier frequency of the digital data signal is determined, if the step of scanning the frequency value results in detection of energy indicative of the digital data signal.

15. The method according to Claim 9, wherein the digital data signal is a DOCSIS signal.

16. The method of scanning according to Claim 14, wherein the frequency value is a first frequency value, and wherein the scanning the first frequency value is followed by scanning a second frequency value to detect energy indicative of the digital data signal, if scanning of the first frequency value fails to detect energy indicative of the digital data signal.

17. The method of scanning according to Claim 16, further comprising scanning the second set of frequencies to attempt to detect the digital data signal, if scanning the first set of frequencies fails to identify the carrier frequency of the digital data signal.

18. In a cable modem, a method of scanning a plurality of frequencies within a channel to detect a carrier frequency of a digital data signal, comprising:
scanning a first set of frequencies to detect a digital data signal; and
scanning a second set of frequencies that are interleaved with the first set of frequencies to detect a digital data signal, if the scanning the first set of frequencies fails to detect a digital data signal.

19. The method of scanning according to Claim 18, wherein the first set of frequencies includes a first frequency and a second frequency, the second frequency being spaced from the first frequency by a predetermined amount.

20. The method of scanning according to Claim 19, wherein the first set of frequencies further comprises a third frequency, the third frequency being spaced from the second frequency by the predetermined amount.

21. The method of scanning according to Claim 20, wherein the predetermined amount is a first predetermined amount, and wherein the second set of frequencies includes a fourth frequency and a fifth frequency, the fifth frequency being spaced from the fourth frequency by the predetermined amount, and the fourth frequency being spaced from the first frequency by a second predetermined amount.

22. The method of scanning according to Claim 21, wherein the fifth frequency is spaced from the second frequency by the second predetermined amount.

23. A cable modem, comprising:
a tuner that is configured to scan a plurality of channels for a carrier frequency of a digital data signal, the digital data signal being received on one of a group of frequencies in one of the plurality of channels; and
a controller that is configured to control the tuner to sequentially scan nonadjacent frequencies in the group of frequencies, wherein each scan of a nonadjacent frequency is capable of detecting energy indicative of the digital data signal from the nonadjacent frequency and from frequencies that are adjacent thereto.

24. The cable modem according to Claim 23, wherein the controller is further configured to control the tuner to scan the frequencies that are adjacent thereto to thereby identify a frequency at which the carrier frequency is located, in response to detecting energy indicative of the digital data signal from the nonadjacent frequency and from frequencies that are adjacent thereto.

25. The cable modem according to Claim 23, wherein the controller is further configured to divide the group of frequencies into a plurality of sets of frequencies at which the carrier frequency may be located, wherein frequencies of each set are interleaved with frequencies of other sets, and to control the tuner to sequentially scan the frequencies of each set.

26. The cable modem according to Claim 25, wherein the group of frequencies are divided into a first set and a second set, and wherein the frequencies of the second set are interleaved with frequencies of the first set.

27. The cable modem according to Claim 25, wherein the group of frequencies are divided into a first set, a second set, and a third set, and wherein the frequencies of the second and third sets are interleaved with frequencies of the first set.

28. The cable modem according to Claim 26, wherein a first frequency in the first set is adjacent second and third frequencies of the second set and wherein the controller is configured to control the tuner to scan the first frequency to detect a digital data signal, and to scan the second and third frequencies in the vicinity of the first frequency, if scanning the first frequency results in detection of energy indicative of the digital data signal at the second or third frequencies.

29. The cable modem according to Claim 28, wherein the controller is further configured to control the tuner to scan the second set of frequencies to attempt to detect the digital data signal, if scanning the first set of frequencies fails to identify the carrier frequency of the digital data signal.

30. A cable modem, comprising:
a tuner that is configured to scan a channel for a carrier frequency of a digital data signal within the channel, the channel including a set of potential carrier frequencies; and
a controller that is configured to control the tuner to sequentially scan a group of nonadjacent potential carrier frequencies selected from the set of potential carrier frequencies, wherein each scan of a nonadjacent potential carrier frequency is capable of detecting energy indicative of the digital data signal from both the nonadjacent potential carrier frequency and from potential carrier frequencies that are adjacent thereto.

31. The cable modem according to Claim 30, wherein the controller is further configured to control the tuner to individually scan the frequencies that are adjacent thereto to thereby identify a frequency at which the carrier frequency is located, in response to detecting energy indicative of the digital data signal from the nonadjacent frequency and from frequencies that are adjacent thereto.

32. The cable modem according to Claim 30, wherein the controller is further configured to divide the group of potential carrier frequencies into a plurality of sets, each of the sets comprising a set of discrete frequency values at which the carrier frequency may be located, wherein discrete frequency values of each set are interleaved with discrete frequency values of other sets, and to control the tuner to sequentially scan the potential carrier frequencies of each set.

33. The cable modem according to Claim 32, wherein the group of potential carrier frequencies are divided into a first set and a second set, and wherein the discrete frequency values of the second set are interleaved with discrete frequency values of the first set.

34. The cable modem according to Claim 32, wherein the group of potential carrier frequencies are divided into a first set, a second set, and a third set, and wherein the discrete frequency values of the second and third sets are interleaved with discrete frequency values of the first set.

35. The cable modem according to Claim 33, wherein the discrete frequency values of the first set include a frequency value and wherein other frequency values are in the vicinity of the frequency value, and wherein the controller is configured to control the tuner to scan the frequency value to detect a digital data signal, and to incrementally scan the other frequency values in the vicinity of the first frequency value until the carrier frequency of the digital data signal is determined, if scanning the frequency value results in detection of energy indicative of the digital data signal.

36. The cable modem according to Claim 30, wherein the digital data signal is a DOCSIS signal.

37. The cable modem according to Claim 35, wherein the frequency value is a first frequency value, and wherein the controller is further configured to scan a second frequency value to detect energy indicative of the digital data signal, if the controller fails to detect energy indicative of the digital data signal during scanning of the first frequency value.

38. The cable modem for according to Claim 37, wherein the controller is further configured to control the tuner to scan the second set of frequencies to attempt to detect the digital data signal, if controller fails to identify the carrier frequency of the digital data signal during scanning of the first set of frequencies.

39. A cable modem, comprising:
a tuner that is configured to scan a plurality of frequencies within a channel to detect a carrier frequency of a digital data signal; and
a controller that is configured to control the tuner to scan a first set of frequencies to detect a digital data signal, and to scan a second set of frequencies that are interleaved with the first set of frequencies to detect a digital data signal, if scanning the first set of frequencies fails to detect a digital data signal.

40. The cable modem according to Claim 39, wherein the first set of frequencies includes a first frequency and a second frequency, the second frequency being spaced from the first frequency by a predetermined amount.

41. The cable modem according to Claim 40, wherein the first set of frequencies further comprises a third frequency, the third frequency being spaced from the second frequency by the predetermined amount.

42. The cable modem according to Claim 41, wherein the predetermined amount is a first predetermined amount, and wherein the second set of frequencies includes a fourth frequency and a fifth frequency, the fifth frequency being spaced from the fourth frequency by the predetermined amount, and the fourth frequency being spaced from the first frequency by a second predetermined amount.

43. The cable modem according to Claim 42, wherein the fifth frequency is spaced from the second frequency by the second predetermined amount.

44. A computer program product that scans a plurality of channels in a cable modem for a carrier frequency of a digital data signal, the digital data signal being received on one of a group of frequencies in one of the plurality of channels, the computer program product comprising a computer-readable storage medium having computer-readable program code embodied therein, the computer program product comprising:
computer-readable program code that is configured to sequentially scan nonadjacent frequencies in the group of frequencies, wherein each scan of a nonadjacent frequency is capable of detects energy indicative of the digital data signal from the nonadjacent frequency and from frequencies that are adjacent thereto.

45. The computer program product according to Claim 44, further comprising:
computer-readable program code that is configured to scan the frequencies that are adjacent thereto to thereby identify a frequency at which the carrier frequency is located, in response to detects energy indicative of the digital data signal from the nonadjacent frequency and from frequencies that are adjacent thereto.

46. The computer program product according to Claim 44, wherein the computer-readable program code that is configured to sequentially scan comprises:
computer-readable program code that is configured to divide the group of frequencies into a plurality of sets of frequencies at which the carrier frequency may be located, wherein frequencies of each set are interleaved with frequencies of other sets; and
computer-readable program code that is configured to sequentially scan the frequencies of each set.

47. The computer program product according to Claim 46, wherein the group of frequencies are divided into a first set and a second set, and wherein the frequencies of the second set are interleaved with frequencies of the first set.

48. The computer program product according to Claim 46, wherein the group of frequencies are divided into a first set, a second set, and a third set, and wherein the frequencies of the second and third sets are interleaved with frequencies of the first set.

49. The computer program product according to Claim 47, wherein a first frequency in the first set is adjacent second and third frequencies of the second set and wherein the computer-readable program code that is configured to sequentially scan comprises:
computer-readable program code that is configured to scan the first frequency to detect a digital data signal; and
computer-readable program code that is configured to scan the second and third frequencies in the vicinity of the first frequency, if scanning the first frequency results in detection of energy indicative of the digital data signal at the second or third frequencies.

50. The computer program product according to Claim 44, wherein the digital data signal is a DOCSIS signal.

51. The computer program product according to Claim 47, further comprising computer-readable program code that is configured to scan the second set of frequencies to attempt to detect the digital data signal, if the computer-readable program code that is configured to scan the first set of frequencies fails to identify the carrier frequency of the digital data signal.

52. A computer program product that scans a channel in a cable modem for a carrier frequency of a digital data signal within the channel, the channel including a set of potential carrier frequencies, the computer program product comprising:
computer-readable program code that is configured to sequentially scan a group of nonadjacent potential carrier frequencies selected from the set of potential carrier frequencies, wherein each scan of a nonadjacent potential carrier frequency is capable of detecting energy indicative of the digital data signal from both the nonadjacent potential carrier frequency and from potential carrier frequencies that are adjacent thereto.

53. The computer program product according to Claim 52, further comprising:
computer-readable program code that is configured to individually scan the frequencies that are adjacent thereto to thereby identify a frequency at which the carrier frequency is located, in response to detecting energy indicative of the digital data signal from the nonadjacent frequency and from frequencies that are adjacent thereto.

54. The computer program product according to Claim 52, wherein the computer-readable program code that is configured to sequentially scan comprises:
computer-readable program code that is configured to divide the group of potential carrier frequencies into a plurality of sets, each of the sets comprising a set of discrete frequency values at which the carrier frequency may be located, wherein discrete frequency values of each set are interleaved with discrete frequency values of other sets; and
computer-readable program code that is configured to sequentially scan the potential carrier frequencies of each set.

55. The computer program product according to Claim 54, wherein the group of potential carrier frequencies are divided into a first set and a second set, and wherein the discrete frequency values of the second set are interleaved with discrete frequency values of the first set.

56. The computer program product according to Claim 54, wherein the group of potential carrier frequencies are divided into a first set, a second set, and a third set, and wherein the discrete frequency values of the second and third sets are interleaved with discrete frequency values of the first set.

57. The computer program product according to Claim 55, wherein the discrete frequency values of the first set include a frequency value and wherein other frequency values are in the vicinity of the frequency value, the computer program product further comprising:
computer-readable program code that is configured to scan the frequency value to detect a digital data signal, and that is configured to incrementally scan the other frequency values in the vicinity of the first frequency value until the carrier frequency of the digital data signal is determined, if the computer-readable program code that is configured to scan the frequency value detects energy indicative of the digital data signal.

58. The computer program product according to Claim 52, wherein the digital data signal is a DOCSIS signal.

59. The computer program product according to Claim 57, wherein the frequency value is a first frequency value, and further comprising computer-readable program code that is configured to scan a second frequency value to detect energy indicative of the digital data signal, if the computer-readable program code that is configured to scan the first frequency value fails to detect energy indicative of the digital data signal.

60. The computer program product according to Claim 59, further comprising computer-readable program code that is configured to scan the second set of frequencies to attempt to detect the digital data signal, when computer-readable program code that is configured to scan the first set of frequencies fails to identify the carrier frequency of the digital data signal.

61. A computer program product that scans a plurality of frequencies within a channel in a cable modem to detect a carrier frequency of a digital data signal, the computer program product comprising:
computer-readable program code that is configured to scan a first set of frequencies to detect a digital data signal; and
computer-readable program code that is configured to scan a second set of frequencies that are interleaved with the first set of frequencies to detect a digital data signal, if the computer-readable program code that is configured to scan the first set of frequencies fails to detect a digital data signal.

62. The computer program product according to Claim 61, wherein the first set of frequencies includes a first frequency and a second frequency, the second frequency being spaced from the first frequency by a predetermined amount.

63. The computer program product according to Claim 62, wherein the first set of frequencies further comprises a third frequency, the third frequency being spaced from the second frequency by the predetermined amount.

64. The computer program product according to Claim 63, wherein the predetermined amount is a first predetermined amount, and wherein the second set of frequencies includes a fourth frequency and a fifth frequency, the fifth frequency being spaced from the fourth frequency by the predetermined amount, and the fourth frequency being spaced from the first frequency by a second predetermined amount.

65. The computer program product according to Claim 64, wherein the fifth frequency is spaced from the second frequency by the second predetermined amount.
